# EUROPÄISCHE PATENTSCHRIFT

(11) **EP 1 065 681 B1**
(45) Veröffentlichungstag und Bekanntmachung des Hinweises auf die Patenterteilung: **24.06.2009**
(21) Anmeldenummer: 00107795.7
(22) Anmeldetag: 11.04.2000
(51) Int. Cl.: H01G 2/02

(54) **Elektrolyt-Kondensator mit hoher Schwingbelastbarkeit**
Electrolytic capacitor with high resistance against vibrations
Condensateur électrolytique avec grande résistance contre les vibrations

(30) Priorität: 28.06.1999 DE 19929598
(43) Veröffentlichungstag der Anmeldung: 03.01.2001
(73) Patentinhaber: EPCOS AG, 81669 München (DE)
(72) Erfinder: Will, Norbert, 89522 Heidenheim (DE); Hebel, Rainer, 89522 Heidenheim (DE); Minihoffer, Rudolf, 89551 Königsbrunn (DE)
(74) Vertreter: Epping - Hermann - Fischer

(56) Entgegenhaltungen:
- DE-A- 1 808 795
- GB-A- 1 071 820
- PATENT ABSTRACTS OF JAPAN vol. 018, no. 556 (E-1620), 24. Oktober 1994 (1994-10-24) & JP 06 204087 A (NIPPON CHEMICON CORP), 22. Juli 1994 (1994-07-22)

## Beschreibung

Die vorliegende Erfindung betrifft einen Elektrolyt-Kondensator in axialer Bauform nach Anspruch 1.

Die Druckschrift JP 06 204087 A beschreibt einen Elektrolyt-kondensator, bei dem ein Papierstreifen im Innern des Kondensatorwickels angeordnet ist.

Die Druckschrift GB-A-1 071 820 beschreibt einen Elektrolyt-kondensator in axialer Ausführung.

Die Druckschrift DE 1 808 795 beschreibt einen Deckelverschluss für Elektrolyt-Becherkondensatoren.

Elektrolyt-Kondensatoren mit beispielsweise einem Aluminiumbecher werden zunehmend auf Printplatten in der Automobilindustrie eingesetzt. Hier sind die Elektrolyt-Kondensatoren starken mechanischen Beanspruchungen ausgesetzt, so daß sie eine hohe Schwingbelastbarkeit aufweisen müssen. Mit anderen Worten, eine zuverlässige und sichere Befestigung der Elektrolyt-Kondensatoren auf den Printplatten ist von großer Bedeutung.

Bisher werden Elektrolyt-Kondensatoren auf Printplatten, die hohen Schwingbelastungen ausgesetzt sind, bevorzugt mit einem Lötstern befestigt. Ein solcher Lötstern gewährleistet zwar eine gewisse Schwingbelastbarkeit des Elektrolyt-Kondensators. Diese ist aber nicht für alle Anforderungen ausreichend. Allgemein wird nämlich die Schwingfestigkeit eines Elektrolyt-Kondensators mit Lötstern durch die Schweißfestigkeit des Lötsternes auf dem Becher und durch die Festigkeit von internen Schweißverbindungen im Elektrolyt-Kondensator begrenzt. Bei zeitlich lang einwirkenden Schwingungen großer Amplitude können gerade diese internen Schweißverbindungen beschädigt werden, was zu Beeinträchtigungen der elektrischen Eigenschaften des Elektrolyt-Kondensators führt.

Aus der DE 182 67 07 U ist ein Elektrolyt-Kondensator bekannt, bei dem ein Stromanschlußstreifen an seinem Ende am Gehäuse des Kondensators festgeklemmt ist. Dieser Elektrolyt-Kondensator hat den Nachteil, daß der nicht eingeklemmte Teil des Anschlußstreifens durch Vibrationen bewegt werden kann, wodurch dieser bei zeitlich lang einwirkenden Schwingungen leicht beschädigt werden kann.

Andere Möglichkeiten zur Befestigung von Elektrolyt-Kondensatoren auf einer Printplatte bestehen in einem Verkleben, das speziell für axiale Elektrolyt-Kondensatoren vorgenommen wird, und in einem Befestigen mittels Schellen, das in erster Linie bei radialen Elektrolyt-Kondensatoren zur Anwendung gelangt.

Bisher ist es aber nicht gelungen, Elektrolyt-Kondensatoren auf einfache Weise auf Printplatten so anzubringen, daß die Elektrolyt-Kondensatoren eine hohe Schwingbelastbarkeit über lange Zeiträume zeigen.

Es ist daher Aufgabe der vorliegenden Erfindung, einen Elektrolyt-Kondensator in axialer Bauform anzugeben, der auf einfache Weise auf einer Printplatte befestigt werden kann und sich durch eine hohe Schwingbelastbarkeit auszeichnet.

Diese Aufgabe wird mit einem Elektrolyt-Kondensator nach Anspruch 1 gelöst Bei dem axialen Elektrolyt-Kondensator nach Anspruch 1 sind so alle Komponenten, die in einem Schwingungsfall eine Eigenbewegung entfalten könnten, nämlich die Verbindungsstreifen vom Wickel zum Becher und von der Kontaktdurchführung zum Wickel und der Wickel selbst fixiert: die Verbindungsstreifen sind nämlich durch den Wickel und den Becherboden bzw. die Scheibe eingeklemmt, so daß eine Eigenbewegung dieser Verbindungsstreifen im Schwingungsfall und damit eine mechanische Belastung der Schweißung und der Verbindungsstreifen sicher vermieden wird. Der Wickel selbst wird dabei ebenfalls fixiert.

Um eine Eigenbewegung zwischen dem Wickel und dem Becher noch zuverlässiger zu vermeiden, kann der Wickel durch eine Mittelsicke in der Becherwandung zusätzlich fixiert werden.

Bei dem Elektrolyt-Kondensator nach Anspruch 1, sind Becherboden und Bördelung jeweils mit einem Verbindungsblech verschweißt.

Die Kräfte, die auf den Becherboden und auf die Scheibe bzw. die Bördelung des Bechers einwirken, werden von den Verbindungsblechen aufgenommen, die am Becherboden und an der Bördelung befestigt sind und mittels Lötpins an der Printplatte angebracht werden können. Damit werden diese Kräfte über die Verbindungsbleche an die Printplatte weitergegeben.

Durch die Verbindungsbleche wird der Elektrolyt-Kondensator an mindestens zwei Seiten, nämlich am Becherboden und an der Scheibe, gehalten, so daß die Schweißverbindungen im Elektrolyt-Kondensator nicht durch Hebelkräfte belastet sind.

Damit wird durch den erfindungsgemäßen Elektrolyt-Kondensator ein Nachteil bestehender Elektrolyt-Kondensatoren mit Lötstern überwunden: bei diesen wirken im Schwingungsfall auf die Schweißstellen zwischen dem Gehäuse des Elektrolyt-Kondensators und dem Lötstern hohe Hebelkräfte ein. Diese Hebelkräfte sind bei dem erfindungsgemäßen Elektrolyt-Kondensator durch dessen waagrechte Anordnung auf der Printplatte und durch die beiden aufgeschweißten Verbindungsbleche erheblich verringert. Auch wird durch die waagrechte Anordnung des Elektrolyt-Kondensators auf der Printplatte der Schwerpunkt des Elektrolyt-Kondensators abgesenkt und dessen Auflagefläche auf der Printplatte vergrößert.

In einer besonders bevorzugten Ausführungsform der Erfindung werden die Verbindungsbleche in ihrer Länge so ausgeführt, daß der Elektrolyt-Kondensator im Abstand über der Printplatte angeordnet ist, so daß zwischen dem Elektrolyt-Kondensator und der Printplatte noch weitere Bauelemente angebracht werden können. Dadurch wird zudem noch Platz auf der Printplatte eingespart.

Nachfolgend wird die Erfindung anhand der Zeichnungen näher erläutert. Es zeigen:
- Fig. 1: eine schematische Schnittdarstellung eines Elektrolyt-Kondensators in axialer Bauform,
- Fig. 2: eine schematische Schnittdarstellung des erfindungsgemäßen Elektrolyt-Kondensators auf einer Printplatte, und
- Fig. 3: eine schematische Darstellung des erfindungsgemäßen Elektrolyt-Kondensators auf einer Printplatte nach einem weiteren Ausführungsbeispiel der Erfindung.

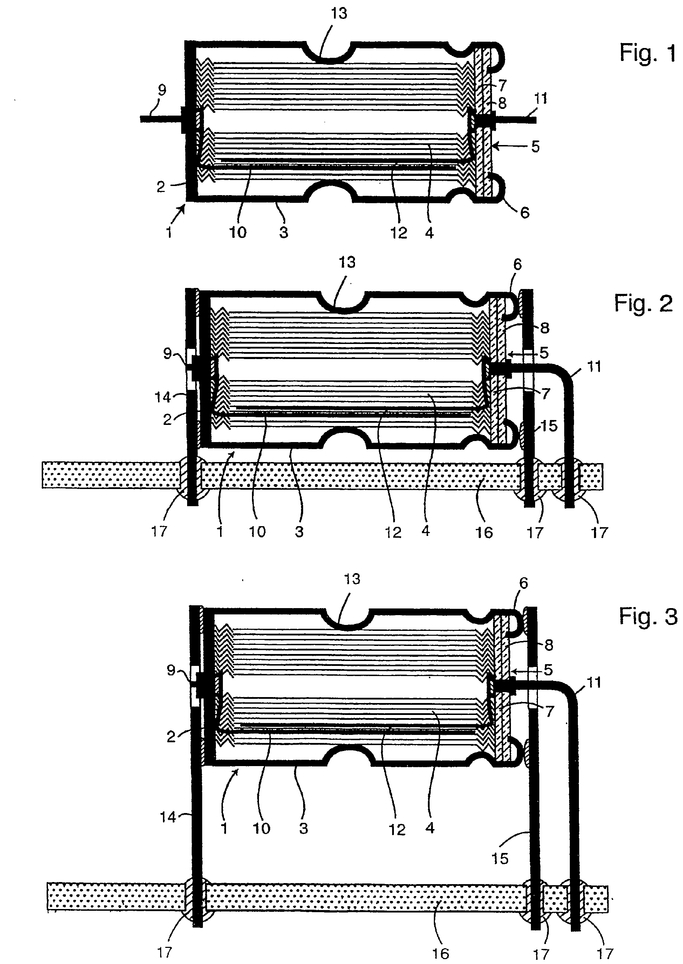

Fig. 1 zeigt einen Elektrolyt-Kondensator mit einem Becher 1 mit einem Becherboden 2 und einer Becherwand 3, einem Wickel 4 und einer Scheibe 5, welche von einer Bördelung 6 des Bechers 1 übergriffen wird. Der Becher 1 besteht aus beispielsweise Aluminium, während die Scheibe 5 zwei Platten 7 und 8 aus isolierendem Material aufweist.

Der Becherboden 2 ist mit einer elektrischen Zuführung 9 versehen, auf die ein Verbindungsstreifen 10 als Verbindung zwischen dem Wickel 4 und dem Becher 1 aufgeschweißt ist. Die Scheibe 5 hat eine Kontaktdurchführung 11, auf die ein weiterer Verbindungsstreifen 12 als Verbindung zwischen dem Wickel 4 und der Kontaktdurchführung 11 aufgeschweißt ist.

In der Becherwand 3 ist eine Mittelsicke 13 vorgesehen, welche den Wickel 4 sicher im Becher 1 fixiert.

Die Verbindungsstreifen 10, 12 sind durch den Wickel 4 und den Becherboden 2 bzw. die Scheibe 5 eingeklemmt, so daß eine Eigenbewegung der Verbindungsstreifen 10, 12 im Schwingungsfall und damit eine mechanische Belastung der Schweißung dieser Verbindungsstreifen zuverlässig verhindert wird.

Bei diesem Aufbau wirken die Kräfte auf den Becherboden 2 und die Scheibe 5 bzw. die Bördelung 6 ein. Diese Kräfte werden, wie in Fig. 2 gezeigt ist, durch Verbindungsbleche 14, 15 aufgenommen, welche auf den Becherboden 2 bzw. die Bördelung 6 aufgeschweißt und mit einer Print- bzw. Schaltungsplatte 16 über Lötpins 17 verlötet sind, was auch für die Kontaktdurchführung 11 gilt. Damit werden die bei Schwingungen im Elektrolyt-Kondensator auftretenden Kräfte über die Verbindungsbleche 14, 15 auf die Printplatte 16 übertragen. Der Elektrolyt-Kondensator ist so "doppelt" mit der Printplatte 16 an solchen Stellen verbunden, an denen die inneren Kräfte im Schwingungsfall unmittelbar auftreten.

Fig. 3 zeigt ein weiteres Ausführungsbeispiel des erfindungsgemäßen Elektrolyt-Kondensators, wobei hier die Verbindungsbleche 14, 15 so lang ausgeführt sind, daß zwischen der Printplatte 16 und dem Elektrolyt-Kondensator noch weitere Bauelemente auf der Printplatte 16 angebracht werden können.

Wesentlich an der Erfindung ist die Verklemmung der Verbindungsstreifen 10, 12 mit dem Wickel im Becher 1. Vorteilhaft ist außerdem die waagrechte Lagerung des Elektrolyt-Kondensators mit den beiden Verbindungsblechen 14, 15, die innere Kräfte des Elektrolyt-Kondensators auf die Printplatte 16 übertragen.

## Patentansprüche

1. Elektrolyt-Kondensator in axialer Bauform mit hoher Schwingbelastbarkeit, umfassend:
- einen einen Wickel (4) aufnehmenden Becher (1),
- eine dem Becherboden (2) gegenüberliegende Scheibe (5), welche von einer Bördelung (6) des Bechers (1) übergriffen ist und welche eine Kontaktdurchführung (11) aufweist,
- einen ersten Verbindungsstreifen (10) vom Wickel (4) zum Becher (1) und
- einen zweiten Verbindungsstreifen (12) von der Kontaktdurchführung (11) zum Wickel (4),
- der erste Verbindungsstreifen (10) zwischen dem Wickel (4) und dem Becherboden (2) und der zweite Verbindungsstreifen (12) zwischen dem Wickel (4) und der Scheibe (5) eingeklemmt ist,
**dadurch gekennzeichnet, daß**
Becherboden (2) und Bördelung (6) jeweils mit einem Verbindungsblech (14, 15) verschweißt sind.

2. Elektrolyt-Kondensator nach Anspruch 1,
**dadurch gekennzeichnet, daß**
der Wickel (4) durch wenigstens eine Mittelsicke (13) der Becherwandung (3) zusätzlich fixiert ist.

3. Elektrolyt-Kondensator nach Anspruch 1 oder 2,
**dadurch gekennzeichnet, daß**
die Verbindungsbleche (14, 15) mittels Lötpins (17) an eine Printplatte (16) anlötbar sind.

4. Elektrolyt-Kondensator nach Anspruch 3,
**dadurch gekennzeichnet, daß**
die Verbindungsbleche (14, 15) eine solche Höhe aufweisen, daß zwischen der Printplatte (16) und dem Elektrolyt-Kondensator auf der Printplatte (16) weitere Bauelemente anbringbar sind.

## Claims

1. Electrolytic capacitor in an axial form of construction with a high vibration load capacity, comprising:
- a cup (1) which accommodates a winding (4),
- a disc (5) which is opposite the cup base (2), is overlapped by a flanged portion (6) of the cup (1) and has a contact bushing (11),
- a first connecting strip (10) from the winding (4) to the cup (1), and
- a second connecting strip (12) from the contact bushing (11) to the winding (4),
- the first connecting strip (10) being clamped between the winding (4) and the cup base (2) and the second connecting strip (12) being clamped between the winding (4) and the disc (5),
**characterized in that**
the cup base (2) and the flanged portion (6) are each welded to a metal connecting sheet (14, 15).

2. Electrolytic capacitor according to Claim 1,
**characterized in that**
the winding (4) is additionally fixed by means of at least one centre bead (13) of the cup wall (3).

3. Electrolytic capacitor according to Claim 1 or 2,
**characterized in that**
the metal connecting sheets (14, 15) can be soldered to a printed circuit board (16) by means of soldering pins (17).

4. Electrolytic capacitor according to Claim 3,
**characterized in that**
the metal connecting sheets (14, 15) have such a height that additional components can be fitted on the printed circuit board (16) between the printed circuit board (16) and the electrolytic capacitor.

## Revendications

1. Condensateur électrolytique, de forme de construction axiale et ayant une grande résistance aux vibrations, comprenant :
- un godet (1) de réception d'un bobinage (4),
- un disque (5) qui est opposé au fond (2) du godet, qu'empiète un bord (6) rabattu du godet (1) et qui a une traversée (11) de contact,
- une première bande (10) de liaison du bobinage (4) au godet (1) et
- une deuxième bande (12) de liaison de la traversée (11) de contact au bobinage (4),
- la première bande (10) de liaison étant serrée entre le bobinage (4) et le fond (2) du godet, la deuxième bande (12) de liaison étant serrée entre le bobinage (4) et le disque (5),
**caractérisé en ce que**
le fond (2) du godet et le bord (6) rabattu sont soudés respectivement à une tôle (14, 15) de liaison.

2. Condensateur électrolytique suivant la revendication 1,
**caractérisé en ce que**
le bobinage (4) est immobilisé supplémentairement par au moins une moulure (13) médiane de la paroi (3) du godet.

3. Condensateur électrolytique suivant la revendication 1 ou 2,
**caractérisé en ce que**
les tôles (14, 15) de liaison peuvent être brasées sur une plaquette (16) imprimée au moyen de plots (17) de brasage.

4. Condensateur électrolytique suivant la revendication 3,
**caractérisé en ce que**
les tôles (14, 15) de liaison ont une hauteur telle que d'autres composants peuvent être mis sur la plaque (16) imprimée entre la plaque (16) imprimée et le condensateur électrolytique.
